Europäisches Patentamt

European Patent Office

Office européen des brevets

(11) Publication number: **0 425 957 A2**

# EUROPEAN PATENT APPLICATION

(21) Application number: 90120205.1

(51) Int. Cl.5: **H01L 21/311, H01L 21/027**

(22) Date of filing: **22.10.90**

(30) Priority: **24.10.89 JP 274971/89**

(43) Date of publication of application:
**08.05.91 Bulletin 91/19**

(84) Designated Contracting States:
**DE FR GB**

The title of the invention has been amended (Guidelines for Examination in the EPO, A-III, 7.3).

(71) Applicant: **Kabushiki Kaisha Toshiba
72, Horikawa-cho Saiwai-ku
Kawasaki-shi(JP)**

(72) Inventor: **Tsuji, Hitoshi, c/o Intellectual
Property Division
Kabushiki Kaisha Toshiba, 1-1 Shibaura
1-chome
Minato-ku, Tokyo 105(JP)**

(74) Representative: **Lehn, Werner, Dipl.-Ing. et al
Hoffmann, Eitle & Partner Patentanwälte
Arabellastrasse 4
W-8000 München 81(DE)**

(54) **Method of manufacturing a semiconductor device involving a step of patterning an insulating layer.**

(57) A method of manufacturing a semiconductor device comprising the steps of forming a first insulating layer (2) on a semiconductor substrate (1), forming a resist film (3) sensitive to electron beams on the first insulating layer (2), applying electron beams onto a predetermined region of the resist film (3), removing unnecessary portions of the resist film (3) by using a developer, thereby forming a remaining pattern resist film (3), forming a second insulating layer (4) on the entire region of the first insulating layer (2) and the remaining pattern resist film (3), simultaneously removing the remaining pattern resist film (3) and the second insulating layer (4) which is formed thereon, thereby forming an opening of a predetermined pattern on the second insulating layer (4), and etching the first insulating layer (2) through the opening, using the second insulation layer (4) as a mask, thereby causing a predetermined region of the semiconductor substrate (1) to be exposed.

F I G. 3

EP 0 425 957 A2

# METHOD OF MANUFACTURING A SEMICONDUCTOR DEVICE

This invention relates to a method of manufacturing a semiconductor device, which is applied to form a minute opening pattern (extraction pattern) having a diameter of 0.2 μm or less.

EB (electron beam) drawing is widely employed as a method for forming a minute opening pattern with a diameter of 0.2 μm or less in an insulating layer and the like for constituting a semiconductor device. In EB drawing, to obtain a minute extraction pattern, an insulating layer and the like are patterned using, in particular, a positive resist consisting of PMMA (polymethylmethacrylate) having high resolution.

A multilayer resist process using a plurality of resist layers, or a method using an image-reversal process and a multilayer resist process are used to form a minute opening pattern. For example, SPIE (The Society of Photo-Optical Instrumentation Engineers), Vol. 773 (1987), pages 61 to 67 discloses a method using an image-reversal process and a multilayer resist process.

When an opening pattern is formed by using a high-resolution resist such as PMMA, since the quality of the resist have been improved and a thin resist film can be formed, high definition of a level of 0.1 μm to 0.05 μm is obtained. However, PMMA is not very much resistant to RIE (reactive ion etching) or heat. Hence, process conditions are strictly limited in the step of etching during transcription.

Moreover, since the resist consisting of PMMA and the like is not highly sensitive to light, a long period of time is required for drawing, and development conditions are also limited in detail. Hence, the throughput in manufacturing semiconductor devices by means of this method is low.

Further, the multilayer resist process requires a larger number of manufacturing steps than a single layer resist process. In addition, although the dimensions of the top resist layer can be measured, the dimensions and configuration of lower resist layers cannot be measured unless the cross section is checked. The dimensions of the opening pattern can be measured by an SEM (scanning-type electronic microscope); however, to measure the dimensions of the cross section precisely, wafers must be broken in the PMMA resist process and in the multilayer resist process.

When the dimensions of an opening pattern are measured by using an SEM without breaking wafers, definition of a level of only 0.2 μm is obtainable in a conventional device, and the resist on the periphery of the opening is charged up during measurement, so that the dimensions cannot be measured.

It is an object of the present invention to provide a method of manufacturing a semiconductor device in which the dimensions of the resist pattern can be measured easily and accurately, and the pattern can be drawn in a short time.

The method of manufacturing a semiconductor device of the present invention comprises the steps of: forming a first insulating layer on a semiconductor substrate; forming a resist film sensitive to electron beams on the first insulating layer; applying electron beams onto a predetermined region of the resist film; removing unnecessary portions of the resist film by using a developer, thereby forming a remaining pattern resist film; forming a second insulating layer on the entire region of the first insulating layer and the remaining pattern resist film; simultaneously removing the remaining pattern resist film and the corresponding portion of the second insulating layer formed thereon, thereby forming an opening of a predetermined pattern in the second insulating layer; and etching the first insulating layer through the opening, using the second insulation layer as a mask, thereby exposing a predetermined region of the semiconductor substrate.

According to the method of the invention, a first insulating layer is formed on a semiconductor substrate, and a remaining pattern made of a negative resist is formed on the first insulating layer. A second insulating layer is formed on the entire region of the first insulating layer and on the remaining pattern. Thereafter, the negative resist is removed, forming an opening pattern in the second insulating layer. The first insulating layer is etched using the opening pattern formed on the second insulating layer as a mask, thereby forming an opening pattern in the first insulating layer.

Since a remaining resist pattern is formed on the substrate, the dimensions of the opening pattern can be measured by measuring the dimensions of the remaining pattern. In addition, since the remaining pattern is made of a negative resist, the resist is hardly damaged even when measurement is performed by an SEM. As a result, the dimensions of the opening pattern can be measured accurately. Further, since a negative resist is used, pattern drawing requires only a short period of time.

This invention can be more fully understood from the following detailed description when taken in conjunction with the accompanying drawings, in which:

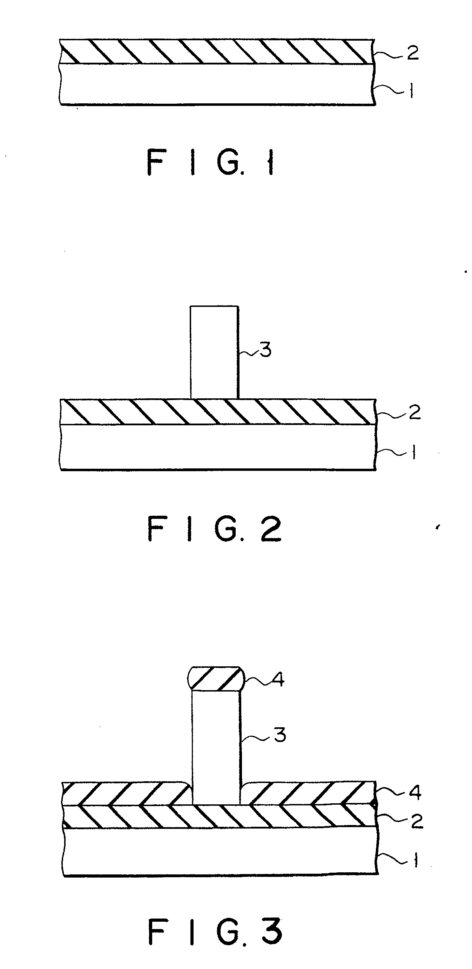

Figs. 1 to 5 show in sequence the steps of manufacturing a semiconductor device according to an embodiment of the present invention.

Embodiments of the present invention will be described below with reference to accompanying drawings.

<Embodiment 1>

In Fig. 1, a substrate 1 is made of GaAs, or is constituted by a GaAs layer and an epitaxial layer of Aℓ-GaAs formed thereon. A first insulating layer 2 made of, for example, $Si_3N_4$ is deposited to 500 ~ 1000 Å thickness on the GaAs substrate 1 since, if the first insulating layer 2 is thinner than 500 Å, it does not fulfill the function of protecting the surface of the GaAs substrate 1 from contamination and if it is thicker than 1000 Å, a pattern conversion error in etching (to be described later) is large, and a long etching time is required.

Next, a negative resist film 3 made of, for example, a novolak resin (SAL601, Gypsy Corporation) which is sensitive to electron beams is formed 0.5 μm thick on the negative resist film 3. Then, a predetermined pattern is drawn on the resist film 3 by an EB exposure device. The pattern is the inversion of the pattern to be ultimately formed on the resist film 3.

Next, as shown in Fig. 2, a 0.1 μm wide remaining pattern of the resist film 3 is formed by developing treatment, and subjected to post-baking.

Subsequently, as shown in Fig. 3, a second insulating layer 4 made of, for example, $SiO_2$ is deposited to a thickness of 500 - 1000 Å over the entire first insulating layer 2 and the resist film 3 by sputtering, which enables deposition at a low temperature. If the second insulating layer 4 is thinner than 500 Å, it does not satisfactorily function as a mask, since the selection rate in an etching process (to be described later) cannot be set at a suitable value, and if the second insulating layer 4 is thicker than 1000 Å, it is difficult to lift off the layer 4 and the resist film 3 together (to be described later). In consideration of this, it is desirable that the second insulating layer 4 has a thickness 60 ~ 70% that of the resist film 3.

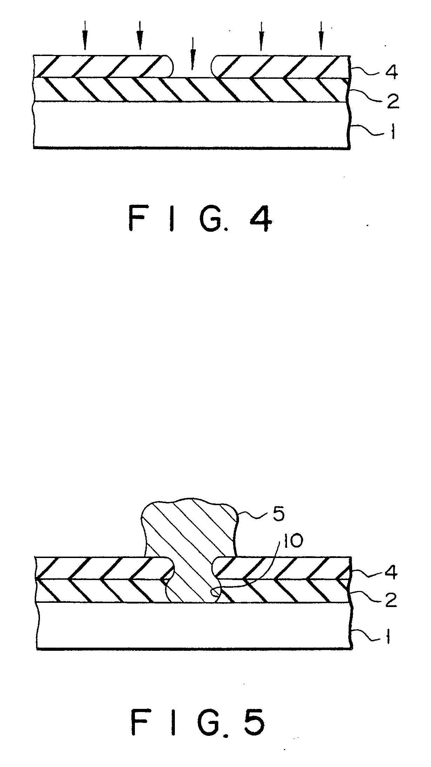

Thereafter, as shown in Fig. 4, the remaining pattern of the resist film 3 and the second insulating film 4 formed thereon are removed by acetone or an ordinary resist lift-off solution.

Next, as shown in Fig. 5, CDE (chemical dry etching) is performed with $CF_4$ + $O_2$ gas using the second insulating layer 4 as a mask, thereby forming an opening pattern 10 in the first insulating layer 2 ($Si_3N_4$). Thereafter, electrode metal 5 is formed on the second insulating layer 4, such that it is brought into contact with a predetermined region of the GaAs substrate 1 via opening pattern 10. Thus, a gate electrode for use in a GaAs •

FET, an HEMT, or the like is formed.

<Embodiment 2>

In this embodiment also, a gate electrode for use in a GaAs • FET, an HEMT, or the like is formed in the same manner as in embodiment 1 through the steps shown in Figs. 1 to 5, except that the first insulating layer 2 and the second insulating layer 4 are respectively made of $SiO_2$ and $Si_3N_4$, and the first insulating layer 2 is removed by means of an RIE method.

First, as shown in Fig. 2, a negative resist film 3 is formed on a first insulating layer 2, and a 0.1 μm wide remaining pattern of the resist film 3 is formed.

Next, as shown in Fig. 3, a second insulating layer 4 made of $Si_3N_4$ is deposited to a thickness of 500 ~ 1000 Å over the entire first insulating layer 2 and the resist film 3 by means of sputtering.

Then, as shown in Fig. 4, the remaining pattern of the resist film 3 and the second insulating film 4 formed thereon are removed by acetone or an ordinary resist lift-off solution.

Next, as shown in Fig. 5, the first insulating layer 2 is dry-etched by an RIE method using $CF_4$ + $O_2$ gas, thereby forming a 0.1 μm wide opening pattern 10 in the first insulating layer 2. Thereafter, electrode metal 5 is formed on the second insulating layer 4, such that it is brought into contact with a predetermined region of the GaAs substrate 1 via opening pattern 10. Thus, a gate electrode for use in a GaAs • FET, an HEMT, or the like is formed.

The opening pattern 10 of 0.1 μm width is formed by the electron beams under the condition of an acceleration voltage of 50 KeV. In this case, when the dosage is 0.4nc/cm, a vertical profile is obtained.

According to the above embodiments 1 and 2, the dimensions of the negative resist film 3 were measured by means of end measuring SEM photography and cross-section measuring SEM photography, and errors were only 0.005 - 0.01 μm with a magnification of about 50,000.

Further, since a remaining pattern of the resist film 3 is formed, it is possible to check whether the side surfaces of the resist are tapered or vertical, and to measure the dimensions of the resist film 3 more easily than in the conventional method.

Moreover, since the resist film 3 is a negative film, the drawing time can be reduced to 1/3 ~ 1/5 of that required where a positive resist film having a low sensitivity is used.

Further, in the conventional method using a positive resist, an electrode metal is formed by a lift-off method immediately after etching is per-

formed using $SiO_2$ as a resist mask, and then the resist removing and cleaning are performed. For this reason, the electrode may be seriously damaged and contaminated. In contrast, according to the above embodiments 1 and 2, since an electrode is formed after patterning, organic substances such as a resist rarely remain on the electrode or adversely affects it.

In the above embodiments 1 and 2, a GaAs substrate is used as a semiconductor substrate; however, a silicon substrate or the like may be used instead.

In addition, the first and second insulating layers 2 and 4 may be made of the same material.

Needless to say, various modifications may be made within the spirit of the invention.

As has been described above, since a remaining resist pattern is formed on the substrate, the dimensions of the opening pattern can be measured easily by measuring the dimensions of the remaining pattern. In addition, since the remaining pattern is made of a negative resist, the drawing time is short and the resist is hardly damaged even when measurement is performed by an SEM.

Reference signs in the claims are intended for better understanding and shall not limit the scope.

## Claims

1. A method of manufacturing a semiconductor device, comprising the steps of:
forming a first insulating layer (2) on a semiconductor substrate (1);
forming a resist film (3) sensitive to electron beams on the first insulating layer (2);
applying electron beams onto a predetermined region of the resist film (3);
removing unnecessary portions of the resist film (3) by using a developer thereby forming a remaining pattern resist film (3),
forming a second insulating layer (4) on the entire region of the first insulating layer (2) and the remaining pattern resist film (3);
simultaneously removing the remaining pattern resist film (3) and the second insulating layer (4) which is formed thereon, thereby forming an opening of a predetermined pattern on the second insulating layer (4); and
etching the first insulating layer (2) through the opening, using the second insulation layer (4) as a mask, thereby causing a predetermined region of the semiconductor substrate (1) to be exposed.
2. A method of manufacturing a semiconductor device according to claim 1, characterized in that said resist film (3) sensitive to electron beams is a negative film.
3. A method of manufacturing a semiconductor device according to claim 1, characterized in that said semiconductor device is made of GaAs.
4. A method of manufacturing a semiconductor device according to claim 1, characterized in that said first and second insulating layers (2, 4) are made of at least one of SiON, SiO, $Si_3N_4$, and $SiO_2$.
5. A method of manufacturing a semiconductor device according to claim 1, characterized in that said first and second insulating layers (2, 4) are 500 ~ 1000 Å thick.

F I G. 1

F I G. 2

F I G. 3

F I G. 4

F I G. 5